# EUROPÄISCHE PATENTSCHRIFT

(11) **EP 1 594 165 B1**
(45) Veröffentlichungstag und Bekanntmachung des Hinweises auf die Patenterteilung: **11.06.2008**
(21) Anmeldenummer: 05009075.2
(22) Anmeldetag: 26.04.2005
(51) Int. Cl.: H01L 21/56, H01L 23/24

(54) **Verfahren zur elektrischen Isolation eines Substrats für ein Leistungsmodul**
Method of electrically insulating a substrate for a power-device
Méthode de isolation électrique d'un substrat pour un dispositif de puissance

(30) Priorität: 04.05.2004 DE 102004021927
(43) Veröffentlichungstag der Anmeldung: 09.11.2005
(73) Patentinhaber: Semikron Elektronik GmbH & Co. KG Patentabteilung, 90431 Nürnberg (DE)
(72) Erfinder: Augustin, Karlheinz, 90768 Fürth (DE); Göbl, Christian, 90441 Nürnberg (DE)

(56) Entgegenhaltungen:
- EP-A2- 0 214 621
- DE-A1- 4 040 822
- JP-A- 61 258 436

## Beschreibung

Die Erfindung beschreibt ein Verfahren zur inneren elektrischen Isolation eines Substrats für ein Leistungshalbleitermodul. Derartige Leistungshalbleitermodule bestehen aus einem rahmenartigen isolierenden Kunststoffgehäuse mit Deckel und einem isolierenden Substrat. Auf dem Substrat ist mindestens eine Leiterbahn und hierauf mindestens ein Leistungshalbleiterbauelement angeordnet. Dieses Leistungshalbleiterbauelement ist mit Anschlusselementen, weiteren Leiterbahnen und / oder weiteren Leistungshalbleiterbauelementen schaltungsgerecht verbunden. Den Stand der Technik derartiger modulintemer Verbindungen bilden Bondverbindungen.

Den Stand der Technik der inneren Isolation derartiger Leistungshalbleitermodule bildet eine dielektrische Isolationsmasse, die als sog. Hartverguss oder als sog. Weichverguss oder als Kombination aus beiden ausgebildet ist. Hartverguss wird auf Grund seiner chemischen Zusammensetzung und der damit verbundenen gesundheitlichen Gefährdung zunehmend weniger eingesetzt. Als Weichverguss haben sich verschieden ausgebildete Silikonkautschukvarianten als Stand der Technik durchgesetzt.

Häufig werden zweikomponentige Silikonkautschvarianten verwendet, die erst kurz vor der Verfüllung des Leistungshalbleitermoduls in einer geeigneten Vorrichtung gemischt werden. Die Verfüllung von Leistungshalbleitermodulen und damit deren innere Isolation wird bis zu einer Füllhöhe durchgeführt, die ein sicheres Bedecken aller relevanten zu isolierenden Komponenten sicherstellt.

Nachteilig an der genannten inneren Isolation von Leistungshalbleitermodulen nach dem Stand der Technik ist, dass der hohe Anteil der Vergussmasse, der nicht zur Isolation notwendig ist, sondern ausschließlich auf Grund einer homogenen Verfüllung im Inneren des Leistungshalbleitermoduls angeordnet ist.
Andere Methoden zur elektrischen Isolation sind ebenfalls bekannt. In JP 61258436 werden die zu isolierenden elektrischen Drähte des Bauteils in Vergussmasse eingetaucht und danach wird durch Umdrehen des Bauteils die Vergussmasse entlang der Drähte verteilt (s. Zusammenfassung).
In EP 0 214 621 wird eine Vergussmasse aufgebracht und danach das Bauteil umgedreht, um die überflüssige Masse abtropfen zu lassen (s. Spalte 3, Zeile 31-55).
In DE 40 40 822 wird nach Auftragen der Vergussmasse das Bauteil um die z-Achse gedreht ("spin-on"-Verfahren). Dadurch wird die Vergussmasse gleichmäßig verteilt und teilweise abgeschleudert (s. Zusammenfassung).

Der vorliegenden Erfindung liegt die Aufgabe zu Grunde ein Verfahren zur inneren elektrischen Isolation eines Substrats für ein Leistungshalbleitermodul vorzustellen, das bei gleich bleibenden elektrischen Eigenschaften die Menge der eingesetzten Isolationsmasse zumindest halbiert.

Diese Aufgabe wird gelöst durch eine Anordnung nach dem Anspruch 1, spezielle Ausgestaltungen finden sich in den Unteransprüchen. Der Grundgedanke der Erfindung geht aus von einem Leistungshalbleitermodul zur direkten Montage auf einem Kühlkörper, wobei das Leistungshalbleitermodul ein rahmenartiges isolierendes Kunststoffgehäuse aufweist. Dieses Kunststoffgehäuse weist weiterhin einen vorzugsweise einstückig mit dem Gehäuse verbundenen Deckel auf. Die zweite Deckfläche wird gebildet durch ein Substrat, das aus einer Isolationsschicht und mindestens einer hierauf angeordneten metallischen Schicht besteht, die dem Leistungshalbleitermodulinneren zugewandt ist. Diese metallische Schicht kann in sich strukturiert sein und bildet die mindestens eine Leiterbahn des Leistungshalbleitermoduls. Auf dieser Leiterbahn ist mindestens ein Leistungshalbleiterbauelement angeordnet und mit mindestens einem nach außen führenden Anschlusselement, einer weiteren Leiterbahn und / oder einem weiteren Leistungshalbleiterbauelement schaltungsgerecht verbunden.

Die erste Ausgestaltung des erfindungsgemäßen Verfahrens weist folgende wesentliche Schritte auf:
- Ausbilden des Substrats. Hierzu wird das mindestens eine Leistungshalbleiterbauelement auf einer Leiterbahn vorzugsweise löttechnisch angeordnet. Anschließend werden die schaltungsgerechten Verbindungen zwischen dem Leistungshalbleiterbauelement, den Anschlusselementen, weiteren Leiterbahnen und / oder weiteren Leistungshalbleiterbauelementen hergestellt. Derartige Verbindungen werden vorzugsweise mittels Draht- oder Bandbondverbindungen hergestellt.
- Überziehen des Substrats mit einer zähflüssigen dielektrischen Isolationsmasse. Hierzu haben sich Gießverfahren als vorteilhafter wiesen, da hierbei die Isolationsmasse auch beispielsweise durch Bonddrähte überdeckte Bereiche sicher verfüllt. Das Gießverfahren kann zu dessen Beschleunigung druckunterstützt sein.
- Einleiten der Vernetzung der Isolationsmasse. Vorteilhafterweise finden in dem erfindungsgemäßen Verfahren Isolationsmassen Verwendung, deren Vernetzung mittels Einwirkung von ultraviolettem Licht oder von Temperatur eingeleitet wird. Eine vollständige Vernetzung der Isolationsmasse ist zu diesem Zeitpunkt des Verfahrens zu vermeiden.
- Drehen des Substrats um seine Längsachse (x-Achse). Hierdurch kann die überschüssige Isolationsmasse abtropfen und vorhandene Bondverbindungen sicher mit Isolationsmasse umhüllen. Im Verlauf dieses Abtropf- und Umhüllungsvorgangs vernetzt die Isolationsmasse weiter. Eine vollständige Vernetzung ist während dieses Verfahrensschritts möglich, bevorzugt ist allerdings, dass auch während dieses Verfahrensschritts die Vernetzung noch nicht vollständig ist.
- Anordnen des Substrats in dem Gehäuse des Leistungshalbleitermoduls. Bei einer noch nicht vollständig vernetzten Isolationsmasse wirkt diese hierbei vorteilhafterweise noch als adhäsiver Stoff, der eine Klebeverbindung zwischen dem Gehäuse und dem Substrat herstellt.

Besonders vorteilhaft ist das Gießverfahren, wenn es druckunterstützt ist und / oder wenn ein Drallstrahlgießverfahren nach dem Stand der Technik angewandt wird, da hierbei die Isolationsmasse schnell und gleichmäßig auf dem Substrat verteilt wird.

Die zweite Ausgestaltung des erfindungsgemäßen Verfahrens weist folgende wesentliche Schritte auf:
- Ausbilden des Substrats gemäß erster Ausgestaltung.
- Eintauchen des Substrats mit der mit dem mindestens einen Leistungshalbleiterbauelement bestückten Seite in die dielektrischen Isolationsmasse. Hierbei dringt die Isolationsmasse in alle Zwischenräume, wie sie beispielhaft unterhalb der Bondverbindungen vorhandener sind, ein. Während des Herausziehens und einer optionalen zusätzlichen Wartezeit kann die überschüssige Isolationsmasse abtropfen und umhüllt hierbei insbesondere auch die vorhandenen Bondverbindungen mit Isolationsmasse.
- Einleiten der Vernetzung der Isolationsmasse gemäß erster Ausgestaltung. Gegenüber dem vorhergehenden Verfahrensschritt wird die Lage des Substrats mit der bestückten Seite nach unten beibehalten. Somit wird sichergestellt, das eine ausreichende Umhüllung der Bondverbindungen erreicht wird. Es ist in diesem Verfahrensschritt analog zur ersten Ausgestaltung bevorzugt, dass die Vernetzung noch nicht vollständig ist.
- Abtropfen von überschüssiger Isolationsmasse und sichere Umhüllung vorhandener Bondverbindungen mit Isolationsmasse analog erster Ausgestaltung.
- Anordnen des Substrats in dem Gehäuse des Leistungshalbleitermoduls gemäß erster Ausgestaltung.

Vorteilhaft an beiden Ausgestaltungen des erfindungsgemäßen Verfahrens ist, dass alle zu isolierenden Teile des Leistungshalbleitermoduls, besonders auch die Bondverbindungen, ausreichend mit der dielektrischen Isolationsmasse benetzt und umhüllt sind.

Weiterhin vorteilhaft ist bei beiden Ausgestaltungen des erfindungsgemäßen Verfahrens, wenn das Substrat während des Abtropfens zeitweise um seine Hochachse (z-Richtung) in Ration versetzt wird um somit das Abtropfen zu beschleunigen.

Ebenso vorteilhaft ist es, wenn während des Abtropfverfahrensschritts das Substrat mit Vakuum beaufschlagt wird, da hierdurch eventuell vorhandene Gaseinschlüsse in der Isolationsmasse wirksam entfernt werden.

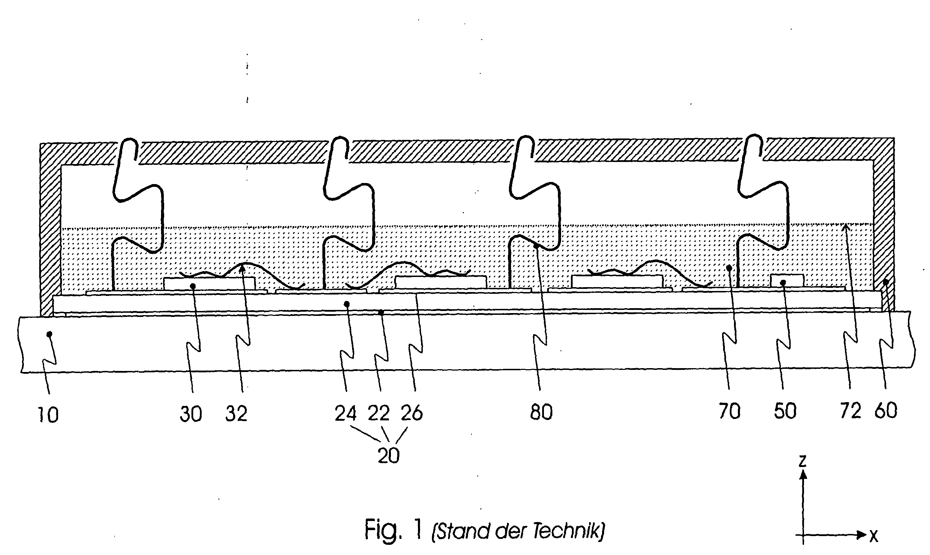

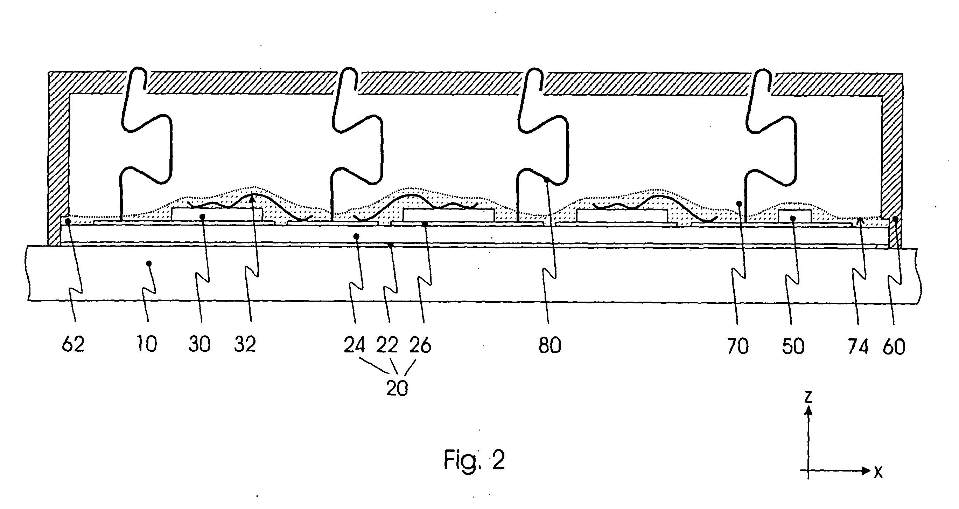

Die Erfindung wird weiterhin in Verbindung mit den Fig. 1 und 2 näher erläutert.

Fig. 1 zeigt einen Schnitt durch ein Leistungshalbleitermodul nach dem Stand der Technik.

Fig. 2 zeigt ein Leistungshalbleitermodul mit erfindungsgemäß ausgebildeter innerer Isolation.

Fig. 1 zeigt einen Schnitt durch ein Leistungshalbleitermodul nach dem Stand der Technik. Dargestellt ist ein Kühlkörper (10), ein hierauf angeordnetes Substrat (20) des Leistungshalbleitermodul sowie dieses umrahmend und überdeckend ein Gehäuse (60)

Das Substrat (20) besteht aus einem Isolierstoffkörper (24), vorzugsweise einer Industriekeramik wie Aluminiumoxid oder Aluminiumnitrit, sowie auf beiden Seiten dieses Isolierstoffkörpers metallischen Schichten (22, 26). Die metallischen Schichten sind hierbei mittels des bekannten DCB- Verfahrens auf dem Isolierstoffkörper (24) aufgebracht. Vorzugsweise ist die dem Inneren des Gehäuses (60) zugewandete metallische Schicht (26) in sich strukturiert und bildet somit von einander isolierte Leiterbahnen. Diese Leiterbahnen tragen Leistungshalbleiterbauelemente (30), wie Dioden, Thyristoren, IGBTs und / oder MOS-FETs und Sensorbauelemente (50), die hierauf mittels Lötverbindungen angeordnet sind. Weitere schaltungsgerechte Verbindungen der Leistungshalbleiterbauelemente (30) mit weiteren Leiterbahnen (26) erfolgen mittels Drahtbondverbindungen (32).

Die Verbindungselemente zur elektrischen Verbindung der Leiterbahnen (26) des Substrats (20) mit den externen Zuleitungen wird von Kontaktfedern (70) gebildet.

Die innere Isolierung des Leistungshalbleitermoduls wird gebildet durch einen Silikonkautschuk (70), der das Innere des Leistungshalbleitermodul bis auf circa halbe Höhe ausfüllt. Die dem Substrat (20) abgewandte Oberfläche (72) des Silikonkautschuks bildet daher eine ebene Fläche.

Fig. 2 zeigt ein Leistungshalbleitermodul mit erfindungsgemäß ausgebildeter innerer Isolation. Der Kühlkörper (10) und das Substrat (20) mit den Leistungshalbleiterbauelementen (30) sowie deren schaltungsgerechte Verbindungen sind ebenso wie in Fig. 1 ausgebildet.

Die Isolationsmasse (70) ist hier gemäß einer der beiden Ausgestaltungen des erfindungsgemäßen Verfahrens auf das Substrat (20) aufgebracht worden. Die Isolationsmasse (70) wurde bis an den Rand des Substrats (20) aufgebracht und war vor der Anordnung des Substrats (20) zu dem Gehäuse (60) noch nicht vollständig vernetzt. Das Gehäuse (60) ist hier derart ausgestaltet, dass bei dieser Anordnung zueinander über einen Teil der Gehäusebreite eine Ausnehmung (62) verbleibt. Die in dieser Ausnehmung (62) angeordnete Isolationsmasse (70) wirkt hier nach ihrer vollständigen Aushärtung als Klebeverbindung zwischen dem Gehäuse (60) und dem Substrat (20).

Die durch das erfindungsgemäße Verfahren aufgebrachte Isolationsmasse (70) weist eine Oberfläche (74) auf, die der Kontur des Substrats (20) mit den hierauf angeordneten Leistungshalbleiterbauelementen (30) und den Bondverbindungen (32) folgt. Auf Grund des erfindungsgemäßen Verfahrens und einer hierauf abgestimmten Viskosität der Isolationsmasse (70) zwischen 400 und 1400 mPa·s werden alle Oberflächen des Substrats (20), alle Leistungshalbleiterbauelemente (30) sowie vor allem alle Bondverbindungen (32) zu deren elektrischer Isolation ausreichend bedeckt.

Weiterhin weist die Isolationsmasse (70) folgende Parameter auf: einen spezifischen Durchgangswiderstand von mehr als 10¹⁵ Ohm und eine Dielektrizitätskonstante zwischen 2,5 und 3.

Es ist offensichtlich, dass durch das erfindungsgemäße Verfahren der Ausbildung einer inneren Isolation des Substrats eines Leistungshalbleitermoduls die Menge der verwendeten Isolationsmasse (70) mehr als halbiert werden konnte, ohne die elektrischen Eigenschaften zu verändern.

## Patentansprüche

1. Verfahren zur inneren elektrischen Isolation eines Substrats (20) für ein Leistungshalbleitermodul mit einem rahmenartigen isolierenden Gehäuse (60) mit Deckel und mit einem isolierenden Substrat (20) mit mindestens einer Leiterbahn (26) und mindestens einem hierauf angeordneten Leistungshalbleiterbauelement (30), welches mit Anschlusselementen (80), weiteren Leiterbahnen (26) und / oder Leistungshalbleiterbauelementen (30) schaltungsgerecht vorzugsweise mittels Bondverbindungen (32) verbunden ist, **gekennzeichnet durch** folgende wesentliche Schritte:
• Ausbilden des Substrats (20) mit dem mindestens einen Leistungshalbleiterbauelement (30) und den schaltungsgerechten Verbindungen (32);
• Überziehen des Substrats (20) mit einer zähflüssigen dielektrischen Isolationsmasse (70) in einem Gießverfahren;
• Einleiten der Vernetzung der Isolationsmasse (70);
• Drehen des Substrats (20) um eine Längsachse (x-Achse), damit die Isolationsmasse (70) die vorhandenen Bondverbindungen (32) sicher umhüllt und damit überschüssige Isolationsmasse (70) abtropfen kann;
• Anordnen des Substrats (20) in dem Gehäuse (60) des Leistungshalbleitermoduls.

2. Verfahren zur inneren elektrischen Isolation eines Substrats (20) für ein Leistungshalbleitermodul mit einem rahmenartigen isolierenden Gehäuse (60) mit Deckel und mit einem isolierenden Substrat (20) mit mindestens einer Leiterbahn (26) und mindestens einem hierauf angeordneten Leistungshalbleiterbauelement (30) welches mit Anschlusselementen (80), weiteren Leiterbahnen (26) und / oder Leistungshalbleiterbauelementen (30) schaltungsgerecht vorzugsweise mittels Bondverbindungen (32) verbunden ist, **gekennzeichnet durch** folgende wesentliche Schritte:
• Ausbilden des Substrats (20) mit dem mindestens einen Leistungshalbleiterbauelement (30) und den schaltungsgerechten Verbindungen (32);
• Eintauchen des Substrats (20) mit der mit dem mindestens einen Leistungshalbleiterbauelement (30) bestückten Seite in eine zähflüssige dielektrische Isolationsmasse (70);
• Einleiten der Vernetzung der Isolationsmasse (70);
• Sicheres Umhüllung vorhandener Bondverbindungen (32) mit Isolationsmasse (70) und Abtropfen von überschüssiger Isolationsmasse (70);
• Anordnen des Substrats (20) in dem Gehäuse (60) des Leistungshalbleitermoduls.

3. Verfahren nach Anspruch 1 oder 2,
wobei das Substrat (20) während des Abtropfens zeitweise um seine Hochachse (z-Richtung) in Ration versetzt wird um somit das Abtropfen zu beschleunigen.

4. Verfahren nach Anspruch 1 oder 2,
wobei das Vernetzen der geeigneten Isolationsmasse (70) durch Einwirkung von ultraviolettem Licht eingeleitet wird.

5. Verfahren nach Anspruch 1 oder 2,
wobei das Vernetzen der geeigneten Isolationsmasse (70) durch Einwirkung von Wärme eingeleitet wird.

6. Verfahren nach Anspruch 1 oder 2,
wobei die jeweiligen Abtropfschritte unter Vakuumbeaufschlagung durchgeführt werden.

7. Verfahren nach Anspruch 1 oder 2,
wobei die Isolationsmasse (70) einen spezifischen Durchgangswiderstand von mehr als 10¹⁵ Ohm, eine Viskosität zwischen 400 und 1400 mPa·s und eine Dielektrizitätskonstante zwischen 2,5 und 3 aufweist.

8. Verfahren nach Anspruch 1,
wobei das Überziehen des Substrats (20) mit der dielektrischen Isolationsmasse (70) in einem druckunterstütztem Drallstrahlgießverfahren durchgeführt wird,

## Claims

1. A method for the inner electrical insulation of a substrate (20) for a power semiconductor module with a frame-like insulating housing (60) with a cover and with an insulating substrate (20) with at least one conductor path (26) and at least one power semiconductor component (30) arranged on it, which component is connected to connection elements (80), further conductor paths (26) and/or power semiconductor components (30) suitable for a circuit, preferably by means of bond connections (32), **characterised by** the following essential steps:
- Formation of the substrate (20) with the at least one power semiconductor component (30) and the connections (32) suitable for a circuit;
- Coating of the substrate (20) with a viscous dielectric insulation compound (70) in a casting method;
- Initiation of the cross-linking of the insulation compound (70);
- Rotation of the substrate (20) about a longitudinal axis (x-axis) so that the insulation compound (70) reliably encloses the bond connections (32) present and excess insulation compound (70) is able to drain off;
- Arrangement of the substrate (20) in the housing (60) of the power semiconductor module.

2. A method for the inner electrical insulation of a substrate (20) for a power semiconductor module with a frame-like insulating housing (60) with a cover and with an insulating substrate (20) with at least one conductor path (26) and at least one power semiconductor component (30) arranged on it, which component is connected to connection elements (80), further conductor paths (26) and/or power semiconductor components (30) suitable for a circuit, preferably by means of bond connections (32), **characterised by** the following essential steps:
- Formation of the substrate (20) with the at least one power semiconductor component (30) and the connections (32) suitable for a circuit;
- Immersion of the substrate (20) in a viscous dielectric insulation compound (70) with the side loaded with the at least one power semiconductor component (30);
- Initiation of the cross-linking of the insulation compound (70);
- Reliable enclosure of the bond connections (32) present with insulation compound (70) and draining of excess insulation compound (70);
- Arrangement of the substrate (20) in the housing (60) of the power semiconductor module.

3. The method according to Claim 1 or 2,
wherein the substrate (20) is temporarily set in rotation around its vertical axis (z-direction) during the draining, thereby accelerating the draining.

4. The method according to Claim 1 or 2,
wherein the cross-linking of the suitable insulation compound (70) is initiated by the action of ultraviolet light.

5. The method according to Claim 1 or 2,
wherein the cross-linking of the suitable insulation compound (70) is initiated by the action of heat.

6. The method according to Claim 1 or 2,
wherein the respective draining steps are carried out under a vacuum load.

7. The method according to Claim 1 or 2,
wherein the insulation compound (70) has a specific contact resistance of over 10¹⁵ ohms, a viscosity of between 400 and 1400 mPa.s and a dielectricity constant of between 2.5 and 3.

8. The method according to Claim 1,
wherein the coating of the substrate (20) with the dielectric insulation compound (70) is carried out in a pressure-assisted centrifugal casting method.

## Revendications

1. Procédé pour l'isolation électrique intérieure d'un substrat (20) pour un module à semi-conducteurs de puissance comprenant un boîtier (60) isolant de type cadre avec couvercle et un substrat (20) isolant avec au moins une piste conductrice (26) et au moins un composant à semi-conducteurs de puissance (30) disposé dessus, qui est relié de façon conforme au circuit, de préférence au moyen de connexions par liaison (32), à des éléments de raccordement (80), à d'autres pistes conductrices (26) et/ou à des composants à semi-conducteurs de puissance (30), **caractérisé par** les étapes principales suivantes :
■ réalisation du substrat (20) avec le au moins un composant à semi-conducteurs de puissance (30) et les liaisons (32) conformes au circuit ;
■ recouvrement du substrat (20) avec une masse d'isolation (70) diélectrique semi-liquide dans un procédé de coulée ;
■ démarrage de la réticulation de la masse d'isolation (70) ;
■ rotation du substrat (20) autour d'un axe longitudinal (axe x) pour que la masse d'isolation (70) enveloppe de façon sûre les connexions par liaison (32) existantes et que la masse d'isolation (70) excédentaire puisse s'égoutter ;
■ mise en place du substrat (20) dans le boîtier (60) du module à semi-conducteurs de puissance.

2. Procédé pour l'isolation électrique intérieure d'un substrat (20) pour un module à semi-conducteurs de puissance comprenant un boîtier (60) isolant de type cadre avec couvercle et un substrat (20) isolant avec au moins une piste conductrice (26) et au moins un composant à semi-conducteurs de puissance (30) disposé dessus, qui est relié de façon conforme au circuit, de préférence au moyen de connexions par liaison (32), à des éléments de raccordement (80), à d'autres pistes conductrices (26) et/ou à des composants à semi-conducteurs de puissance (30), **caractérisé par** les étapes importantes suivantes :
■ réalisation du substrat (20) avec le au moins un composant à semi-conducteurs de puissance (30) et les liaisons (32) conformes au circuit ;
■ immersion du substrat (20) avec le côté équipé du au moins un composant à semi-conducteurs de puissance (30) dans une masse d'isolation (70) diélectrique semi-liquide ;
■ amorçage de la réticulation de la masse d'isolation (70) ;
■ enveloppement sûr de connexions par liaison (32) existantes avec de la masse d'isolation (70) et égouttage de la masse d'isolation (70) excédentaire ;
■ mise en place du substrat (20) dans le boîtier (60) du module à semi-conducteurs de puissance.

3. Procédé selon la revendication 1 ou 2,
le substrat (20) étant mis en rotation pendant l'égouttage de façon temporaire autour de son axe vertical (direction z), afin d'accélérer ainsi l'égouttage.

4. Procédé selon la revendication 1 ou 2,
la réticulation de la masse d'isolation (70) appropriée étant amorcée par l'effet de lumière ultraviolette.

5. Procédé selon la revendication 1 ou 2,
la réticulation de la masse d'isolation (70) appropriée étant amorcée par l'effet de chaleur.

6. Procédé selon la revendication 1 ou 2,
les étapes d'égouttage respectives étant effectuées par l'alimentation en vide.

7. Procédé selon la revendication 1 ou 2,
la masse d'isolation (70) présentant une résistance de passage spécifique supérieure à 10¹⁵ ohms, une viscosité comprise entre 400 et 1400 mPa.s et une constante diélectrique comprise entre 2,5 et 3.

8. Procédé selon la revendication 1,
le recouvrement du substrat (20) avec la masse d'isolation (70) diélectrique étant effectué dans un procédé de coulée à jet tournant assisté par pression.
